(19) **Europäisches Patentamt**

**European Patent Office**

**Office européen des brevets**

(11) **EP 1 033 029 B1**

(12) **EUROPEAN PATENT SPECIFICATION**

(45) Date of publication and mention
of the grant of the patent:
**10.07.2002 Bulletin 2002/28**

(51) Int Cl.$^7$: **G06F 11/20**, H04N 1/00

(21) Application number: **98967039.3**

(86) International application number:
**PCT/RU98/00403**

(22) Date of filing: **30.11.1998**

(87) International publication number:
**WO 99/37083 (22.07.1999 Gazette 1999/29)**

(54) **AFFINE TRANSFORMATION MEANS AND METHOD OF AFFINE TRANSFORMATION**

VORRICHTUNG UND VERFAHREN ZUR AFFINE TRANSFORMATION

SYSTEME DE TRANSFORMATION AFFINE ET PROCEDE DE TRANSFORMATION AFFINE

(84) Designated Contracting States:
**DE GB**

(30) Priority: **28.11.1997 GB 9725066**

(43) Date of publication of application:
**06.09.2000 Bulletin 2000/36**

(73) Proprietor: **Acuid Limited**
**Dalkeith, Edinburgh EH22 2NA (GB)**

(72) Inventors:
• **VILKOV, Boris Nikolayevich**
**St. Petersburg, 195176 (RU)**
• **DEAS, Alexander Roger**
**Edinburgh EH22 1JW (GB)**
• **ABROSSIMOV, Igor Anatolievich**
**St.Petersburg, 193168 (RU)**
• **PLISS, Oleg Anatolievich**
**St.Petersburg, 190000 (RU)**

(56) References cited:
**US-A- 5 485 474**

• **KIRSCHNER N: "AN INTERACTIVE
DESCRAMBLER PROGRAM FOR RAMS WITH
REDUNDANCY" QUALITY PRODUCTIVITY
PROFIT, PHILADELPHIA, 15 - 18 NOVEMBER
1982, no. SYMP. 1982, 1 November 1982
(1982-11-01), pages 252-257, XP000746188
INSTITUTE OF ELECTRICAL AND
ELECTRONICS ENGINEERS cited in the
application**

## Description

<u>Technical Field</u>

The present invention relates to a memory unit address transformation means and a method of transformation and may be used, for example, for address transformation from a logical address space into a topological address space in solid state memory devices, including semiconductor, ferroelectric, optical, holographic, molecular and crystalline atomic memories.

The present invention is applicable in particular, though not exclusively, in test systems for engineering test analysis, for example, for processing and representation of defect data, or in memory redundancy allocation systems for establishing a relationship between memory unit addresses in different memory device topologies for the purposes of distribution of spare resources.

<u>Background of the invention</u>

In the memory industry, large electronic systems are produced having hundreds of integrated circuits called devices designed to implement a large number of logical functions. These functions are implemented by the logical design of the system. However, the actual physical structure of the system which specifies the actual physical locations of the electronic components necessary to implement the logical, i.e. electrical, functions, differs from the logical design.

To test memory products after fabrication, different test methods are used, some of them being independent of the physical location of the memory cell, but most requiring knowledge of the placement of every cell. The address presented to the memory device is called the logical, or electrical, address; this may not be the same as the address used to access the physical memory cell or cells, which is called the topological, or physical address (see A.J.van de Goor "Testing Semiconductor Memories: Theory and Practice", publ. by John Wiley & Sons, 1996, pp.429-436). The translation of logical addresses into topological addresses is called address transformation, or mapping. When addresses are transformed, successive logical addresses may transform into non-successive topological addresses. One reason for this difference is that decoders are restricted in size in order to fit the topology of rows and columns of memory cells. A second reason is that, to maintain acceptable production yields, redundant cells are added during manufacture that can be used to replace faulty cells. Spare rows and columns cause a difference in the logical and topological address sequence. Lastly, different chip designs result in chip layouts in which on-chip address pads do not correspond to the standard pin numbers.

The size and density of memory products has increased exponentially over time: from $2^{10}$ bits in 1971 to more than $2^{28}$ bits being sampled by manufacturers today. As the density of memory devices increases, the number of defects in them increases as well. To properly test a memory device, a detailed description of the internal topology and address mapping of the device is required in order to run complex redundancy schemes and optimize testing procedures.

However, storing the address transformation table requires too much space. Besides, reverse transformation requires the same memory space as direct transformation and in the case of restricted memory is not possible. Therefore, means that were adequate for transformation under simpler conditions are far too slow and space consuming in the contemporary environment and often suffer from cost-inefficiency, thus creating a requirement for a system capable of transformation of the addresses using the minimum available space and in the minimum time.

There are numerous mapping schemes described in the literature where a transformation is applied from a logical to a physical space. For example, US 4,774,652 describes a memory mapping scheme designed to simplify the access of pages in a cache memory system. However, these systems often make the reverse mapping very difficult, requiring a very large table with $2^n$ entries.

A method for storing and retrieving information by using a matrix formed of vectors is described in US 5,485,474. The method provides for reconstructing information without losses by using an inverted matrix. However, the above method does not suggest a technique which may be applied to memory device address transformation.

There are several transformation procedures described in *An Interactive Descrambler Program for RAMs with Redundancy, Kirschner,N. In Proc. IEEE Int. Test Conference, pp. 252-257, 1982*, together with a method of constructing a procedure that can perform the transformation operation to generate transformation tables. The known transformation means can scramble the address lines of a 64 Kbit memory chip using an 8-bit row address and a 8-bit column address. The equations describing the transformation operation for the row-select lines $r_0$ through $r_7$ are given below, however in the construction of the mapping, there is no simple scheme for ensuring the reversibility of the map.

$$r_0 = a_0 \text{ XOR } a_2 \text{ XOR } A_7$$
$$r_1 = a_1 \text{ XOR } a_2 \text{ XOR } A_7$$
$$r_2 = a_2 \text{ XOR } A_7$$
$$\dots\dots\dots\dots\dots\dots\dots\dots\dots\dots\dots\dots\dots\dots$$
$$r_6 = a_6 \text{ XOR } a_7$$
$$r_7 = a_7$$

Summary of the Invention

It is an object of the present invention to provide a configurable transformation means for memory unit address mapping, for example from logical into topological address space, with the advantages of reducing the required memory space and the time required for transformation, and also enabling the reverse mapping to be obtained easily. Furthermore, it is an object of the present invention to simplify in various applications the definition of redundancy allocation constraints by applying a user configurable transformation.

The substance of the present invention is a transformation means, as defined in claim 1, for transforming memory unit addresses between different memory device topologies, wherein the transformation means are capable of configurable mapping represented as affine transformation in $\mathbf{P}^n$ space, where n denotes the total number of bits in an address, and P is the modulo 2 field. The proposed system also provides the reverse transformation procedure. The present invention relates further to a computer implemented method, as defined in claim 9, of affine transformation of memory addresses.

Another aspect of the present invention is a memory device testing and analysing system, as defined in claim 10, comprising a fault data storing and analysing means and a testing means provided with transformation means for address transformation between logical address space and physical (topological) address space, wherein the transformation means represents transformation as affine transformation in $\mathbf{P}^n$ space, where n denotes the total number of bits in an address, and P is the modulo 2 field. The proposed system also provides the reverse transformation procedure. The present invention relates further to a method, as defined in claim 11 of operation of the proposed system.

Still another aspect of the present invention is a memory redundancy allocation system, as defined in claim 12, comprising a fault data storing and analysing means and an allocation means, which further contains a transformation means for transforming cell addresses which represents or modifies constraints between memory regions that are physically separate on the actual memory device by applying an affine transformation to map regions sharing a mutual constraint or a mutual spare resource into adjacent regions in a mapping space for the purpose of redundancy allocation wherein transformation means represents transformation as affine mapping in $\mathbf{P}^n$ space, where n denotes the total number of bits in an address, and P is the modulo 2 field. The method corresponding thereto is defined in claim 13.

The invention may be implemented in a hardware system for taking the information about a memory device received, e.g. from a testing system, expressed in terms of logical addresses of faults, and computing corresponding data expressed in terms, for example, of physical layout defects, for enabling repair means to repair the memory device. Furthermore, the corresponding data may be obtained in terms of redundancy allocation procedures for enabling an allocation means to create a repair solution. Alternatively, the present invention may be implemented in a software program for performing the proposed method of address transformation.

The present invention provides also the reverse transformation, sometimes called descrambling, for example, of the transformed addresses expressed in terms of topological, i.e. physical layout defects and producing the corresponding data relating to logical address space for addressing a memory device under treatment. The proposed systems requires minimum memory space and time for storing and processing defect data and allows the use of a wide spectrum of mapping classes.

For a better understanding of the present invention and to show how the same may be carried into effect, reference will now be made, by way of example, without loss of generality, to the accompanying drawings in which:

Fig.1 shows a block scheme of the memory device testing system using the transformation means in accordance with the first embodiment of the present invention.

Fig.2 shows an example illustrating in detail the transformation procedure from logical into physical address space using the transformation means according to the first embodiment of the present invention.

Fig.3 shows an example flow chart of the reverse transformation procedure.

Fig.4 shows an example illustrating an alternative method of operation of the transformation means showing the transformation procedure from physical into another two-component address space, e.g., address space suitable for redundancy allocation.

Fig.5 illustrates one of the preferred software implementation of the method of transformation according to the present invention.

Fig.6 is a fragmentary circuit illustrating one of the hardware implementation of the transformation means according to the present invention.

Fig.7 shows a block scheme of a memory redundancy allocation system using the transformation means in accordance with the present invention.

Fig.8 illustrates the use of the affine transformation in conjunction with memory redundancy allocation.

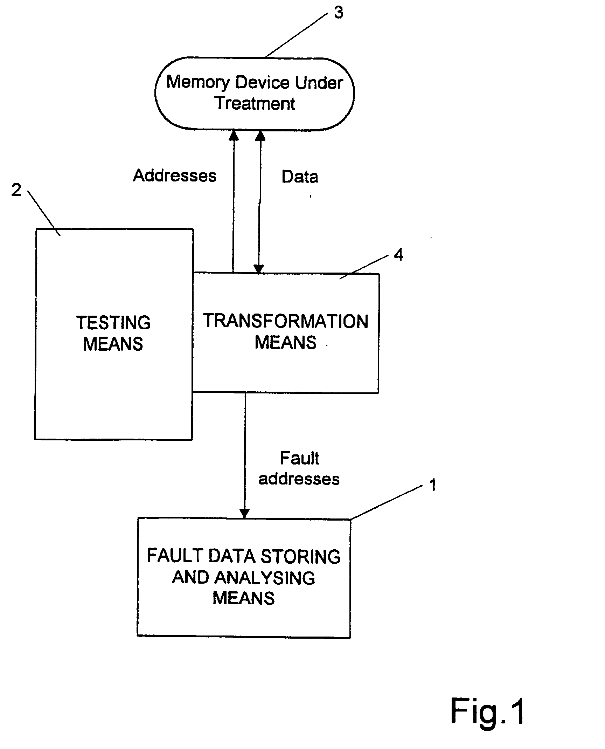

According to the first embodiment of the present invention, the affine transformation means is adapted to perform the transformation from logical into physical address space and the reverse transformation. As shown in Fig. 1, a memory test system using the transformation means according to the present invention consists of a fault data storing and analysing means 1 for storing fault data, testing means 2 for testing a memory device 3 under treatment, provided with a transformation means 4 for transformation of fault addresses from logical into topological (physical) address space and for the reverse transformation. The system operates as follows. After generating fail addresses, testing means 2 subject them to transformation in the transformation means 4. The transformed (scrambled) address data expressed in terms of topological address space are then transferred to the storing and analysing means 1 for processing and storage. The use of the affine transformation means proposed in the present invention allows subjecting the address data in the topological address space, if necessary, to the reverse transformation to obtain logical addresses.

According to the present invention, the transformation means resolves the problem of assigning each input address to the corresponding output address using the formula:

$$V_{joined} = M_{joined} \cdot U_{joined} + t_{joined},$$

wherein $U_{joined}$ is an input address vector, e.g. logical address vector combined of bits of row, column and DQ addresses (where DQ is a bidirectional data pins);

$V_{joined}$ is an output address vector, e.g. physical address vector combined of bits of row and column addresses; $M$ is a mapping matrix represented as an array in $P^n$ space, and $t$ is a translation vector in $P^n$ space, where n is the total number of bits in an address, e.g. the sum of the number of bits in a row and column address in the physical address space, or the sum of the number of bits in a row, column and DQ address in the logical address space.

Mapping matrices and translation vectors may be easily obtained by a specialist ordinary skilled in the art from formulas supplied by the manufacturer. It shall be also mentioned that the term "vector", as used herein to define a processor's word, is customary in the special literature and should not be considered as limiting the proposed invention.

The address transformation means may be implemented in hardware by either using two stores containing the transformation tables showed below, or a set of exclusive OR gates and inverters (the transformations have the property of being able to be expressed by a network of exclusive OR gates and inverters, each carrying out a unitary operation, hence their position in the logic process is not important, but only the number of inversions and the number of exclusive ORs as well as which operands are used). The logical network is apparent from the following transformation example. The transformation means can also be implemented in a software program created in any suitable computer language, e.g. C, C++, Assembler, etc.

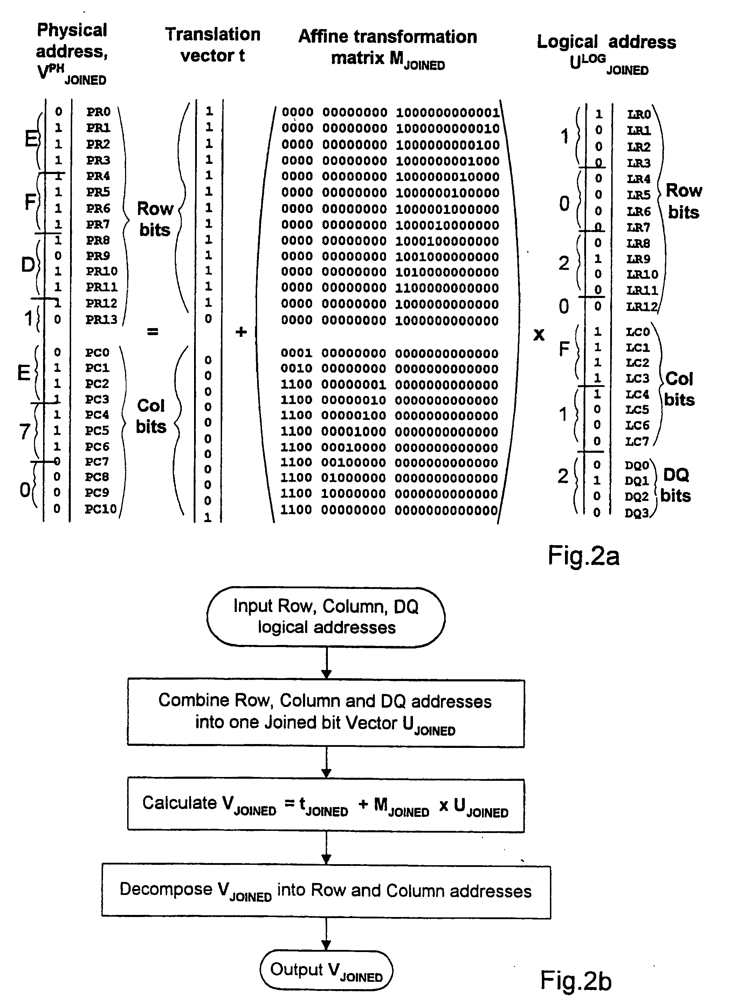

The first method of the operation of the transformation means in accordance with the present invention is shown in Fig.2. To perform the transformation, for example, from logical into physical address space, the transformation means (called also Scrambler) starts to operate upon receipt of the following information in bit form about a memory device: a) logical row addresses, **LR**; b) logical column addresses, **LC**; and c) the number of the plane in logical address, **DQ**. On the basis of this information, the transformation means combines bits of row, column and **DQ** addresses into one (joined) input bit vector $U_{joined}$. The vector $U_{joined}$ is multiplied by mapping matrix **M** and then a translation vector t is added to the result to obtain the output vector $V_{joined}$.

An example of such an operation will now be presented and explained in detail with reference to Fig.2. Suppose, the transformation formulas are as follows:

| | |
|---|---|
| PR0=!LR0^LR12 | PR13=LR12 |
| PR1=!LR1^LR12 | PC0=DQ0 |
| PR2=!LR2^LR12 | PC1=DQ1 |
| PR3=!LR3^LR12 | PC2=LC0^DQ2^DQ3 |

(continued)

| | |
|---|---|
| PR4=!LR4^LR12 | PC3=LC1^DQ2^DQ3 |
| PR5=!LR5^LR12 | PC4=LC2^DQ2^DQ3 |
| PR6=!LR6^LR12 | PC5=LC3^DQ2^DQ3 |
| PR7=!LR7^LR12 | PC6=LC4^DQ2^DQ3 |
| PR8=!LR8^LR12 | PC7=LC5^DQ2^DQ3 |
| PR9=!LR9^LR12 | PC8=LC6^DQ2^DQ3 |
| PR10=!LR10^LR12 | PC9=LC7^DQ2^DQ3 |
| PR11=!LR11^LR12 | PC10=!DQ2^DQ3 |
| PR12=!LR12^DQ3 | |

where

PRn - n-th bit in physical (topological) row address;
in this case, n = 0,1...13, i.e. the total number of bits in row address is 14;
PCn - n-th bit in physical (topological) column address; in this case, n = 0, 1...10, i.e. the total number of bits in column address is 11;
LRn - n-th bit in logical row address; in this case, n = 0, 1...12, i.e. the total number of bits in row address is 13;
LCn - n-th bit in logical column address; in this case, n = 0, 1...7, i.e. the total number of bits in column address is 8;
DQn - n-th bit in logical address representing the number of the plane in logical address, in this case, n = 0, 1...3, i.e. the total number of bits in DQ address is 4.

On the basis of these formulas, the following matrix of size 25 x 25 bits and the translation vector are obtained:

Translation Vector **t**: 1000000000001111111111111
Transformation Matrix **M[25:0][25:0]:**

```
0000000000001000000000001
0000000000001000000000010
0000000000001000000000100
0000000000001000000001000
0000000000001000000010000
0000000000001000000100000
0000000000001000001000000
0000000000001000010000000
0000000000001000100000000
0000000000001001000000000
0000000000001010000000000
0000000000001100000000000
1000000000001000000000000
0000000000001000000000000
0001000000000000000000000
0010000000000000000000000
1100000000010000000000000
1100000000100000000000000
1100000001000000000000000
1100000010000000000000000
1100000100000000000000000
1100001000000000000000000
1100010000000000000000000
1100100000000000000000000
1100000000000000000000000
```

Let the input logical address be:
DQ : 2; Row : 0201(Hex); Col : 001F (Hex).

The corresponding input address vector **U**joined combined of bits of row, column and DQ address is shown in Fig.2a. After performing the transformation as described in the flow chart shown in Fig.2b, the output address vector **V**joined is obtained, which decomposed in row and column components as follows:

Row : 1DFE (Hex) ; Col : 007E(Hex).

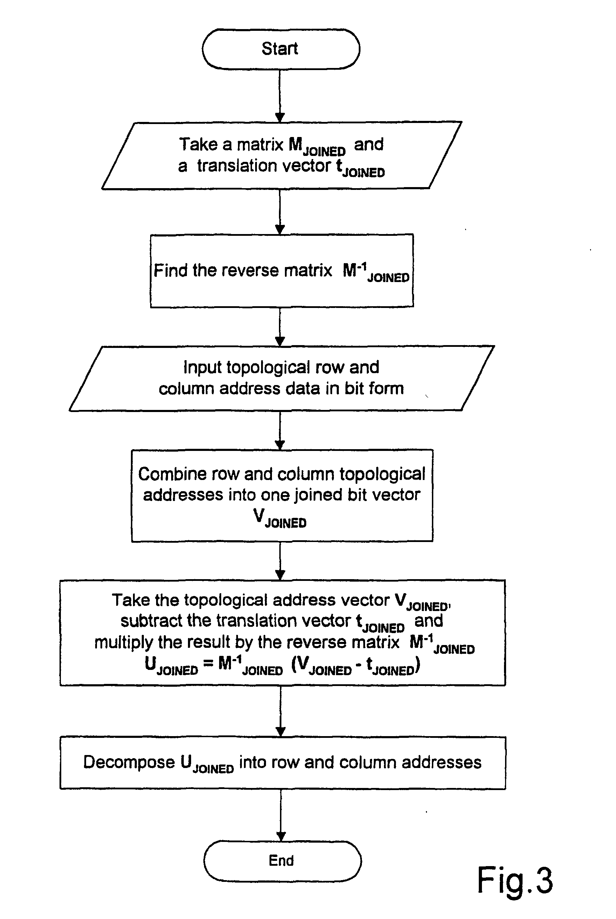

The flow chart of the reverse transformation procedure is shown in Fig.3. In case of the reverse transformation from physical (topological) address space into logical address spaces, the transformation means first subtracts the translation vector t from the topological address vector $\mathbf{V_{joined}}$, and multiplies the result by the reverse matrix $\mathbf{M^{-1}}$. The result is a bit vector $\mathbf{U_{joined}}$ of the logical address:

$$M^{-1}{}_{joined} \, (V_{joined} - t_{joined}) = U_{joined},$$

where the reverse matrix $\mathbf{M^{-1}}_{joined}$ (descrambling matrix) is as follows:

```
0000000000001000000000000001
0000000000001000000000000010
0000000000001000000000000100
0000000000001000000000001000
0000000000001000000000010000
0000000000001000000000100000
0000000000001000000001000000
0000000000001000000010000000
0000000000001000010000000000
0000000000001000100000000000
0000000000001001000000000000
0000000000001010000000000000
0000000000001100000000000000
1000000100000000000000000000
1000001000000000000000000000
1000010000000000000000000000
1000100000000000000000000000
1001000000000000000000000000
1010000000000000000000000000
1100000000000000000000000000
0000000001000000000000000000
0000000010000000000000000000
1000000000011000000000000000
0000000000011000000000000000
```

Both the transformation matrix and the reverse matrix are affine matrices in $\mathbf{P^n}$ space, where $\mathbf{n}$ - the total number of bits in an address, and $\mathbf{P}$ is the modulo 2 field.

The result of the transformation means operation is that logical addresses may be transformed into topological addresses for use in the storing system or laser repair means and topological addresses may be transformed into logical addresses for use by testing means.

Various modifications of the transformation procedure are possible within the scope of the present invention.

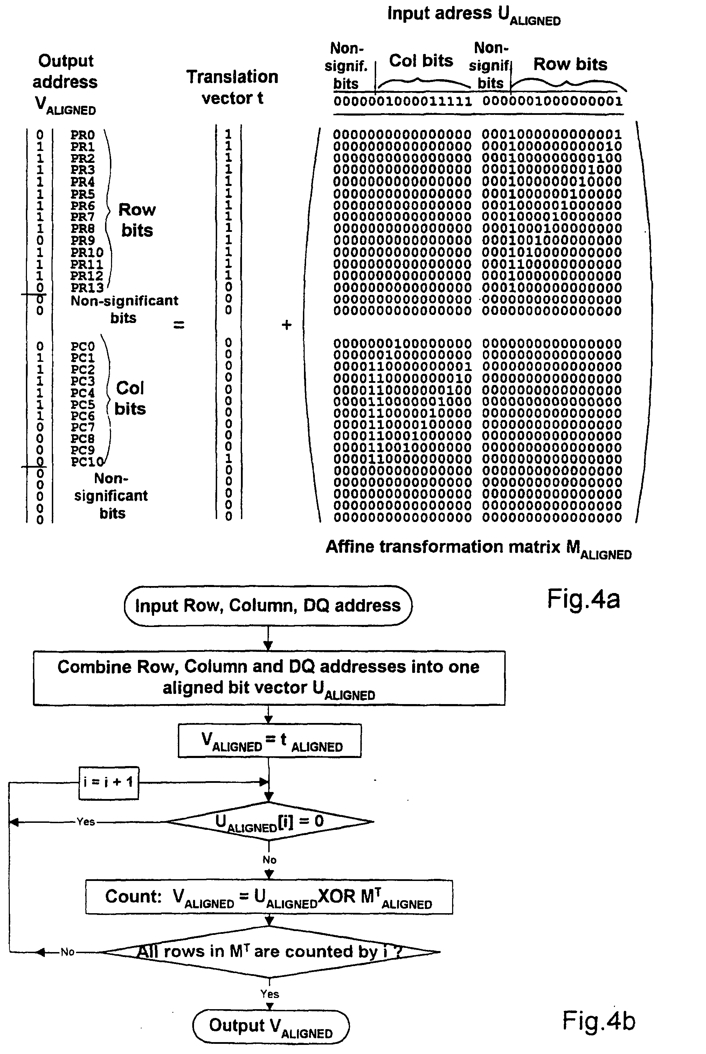

One of the preferred embodiments of the method of performing the transformation will now be illustrated with reference to Fig.4.

The characteristic feature of the method is transposing the mapping matrix. The result of this step is that each vertical line will correspond now to a single machine word. The width of such word in conventional processors equals to 32 bit, however, the address vector size is not limited to this figure.

Another important feature is combining bits of address components, e.g., row and column address bits, in such a way, that they are not joined, as in the previous example, but are aligned according to the admissible word width, so as to obtain, e.g. a 32 bit word, as shown in Fig.4a. In this case, non-significant bits may be added to address bits to obtain a corresponding input address vector and to accelerate the operation.

For the same transformation formulas shown above, the transformation means now performs the following operation:

$$\mathbf{V_{aligned}}\,[n{:}0] = \mathbf{U_{aligned}} \; \mathbf{XOR} \; \overset{n}{\underset{k=0}{\mathbf{M^T}_{aligned}}} \,[n{:}0][n{:}0],$$

and the whole transformation procedure may be carried out in following steps (see Fig.4b):

a) begin $\mathbf{V_{aligned}}$ [n:0] = t;
b) if $\mathbf{U_{aligned}}$ [i]= 0, skip the next two steps;
c) take a vertical line $\mathbf{M}$ [i] [n:0] from matrix $\mathbf{M_{aligned}}$ (each line consisting of a single n-bit word),
d) make XOR operation upon the output word $\mathbf{V_{aligned}}$ counted in a previous step and the word taken from matrix **M** in step (b).

The main advantages of the preferred way of performing the transformation as disclosed above are that, first, it allows transforming addresses much faster than transformation procedures conventionally used; second, the method does not require checking for being non-contradictory, i.e. checking that the incoming address is not out of space (it simply ignores the extra set bits); third, it is much more simple due to decreasing the number of XOR operations used for transformation.

To speed up the above-disclosed procedure even more, Look Up Tables (LUT) may be used to store partial results of the calculations. Thus, to simplify the procedure of performing the transformation for a 32-bit input address, the input word may be splitted into two 16-bit parts, with the two LUT created, respectively, each LUT comprising 16 addresses and 32 bits of data. Thus, the resulting procedure will contain the following operation:

$$V_{OUTPUT}[31:1] = LUT\_High\ [U_{INPUT}[31:15]]\ XOR\ LUT\_LowU_{INPUT}[15:0]]$$

The LUT size may be varied depending of the particular application and the available memory resources. For example, for some applications it is possible to create two large none cacheable tables to perform just one XOR operation but have two memory accesses.

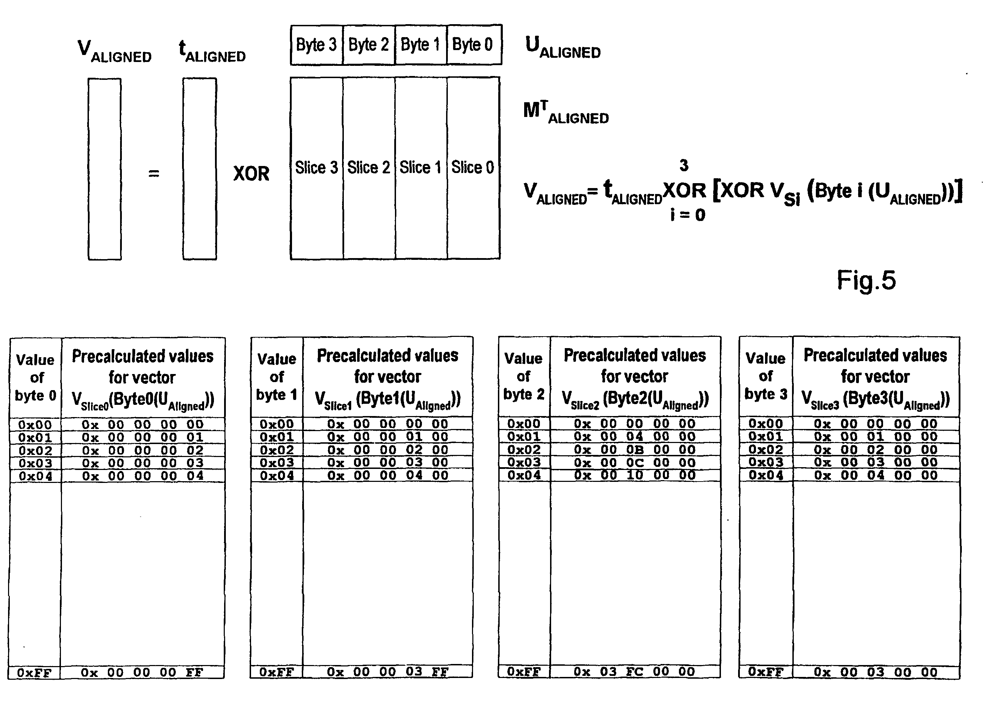

For some other applications it may be preferable to employ four comparatively small tables each of a size 256 x 32 bits, i.e. smaller than the processor's internal cache size, the total size being 4 Kbytes. As shown in the example presented in Fig.5, the input address $U_{aligned}$ is splitted into four parts consisting of bytes 0, 1, 2 and 3, respectively. The matrix M is sliced accordingly into a respective Slices 0, 1, 2 and 3. For each byte of the input address vector, a corresponding partial vector **Vs** of the output vector **V$_{ALIGNED}$** is pre-calculated and stored in the cache memory.

For some applications, even smaller LUT size may give better results.

The proposed technical solution may be implemented both in hardware and software.

The hardware implementation of the transformation means may be created, e.g. using available small memory cells in a Field Programmable Gates Array (FPGA). The size of these memory cells is family dependent.

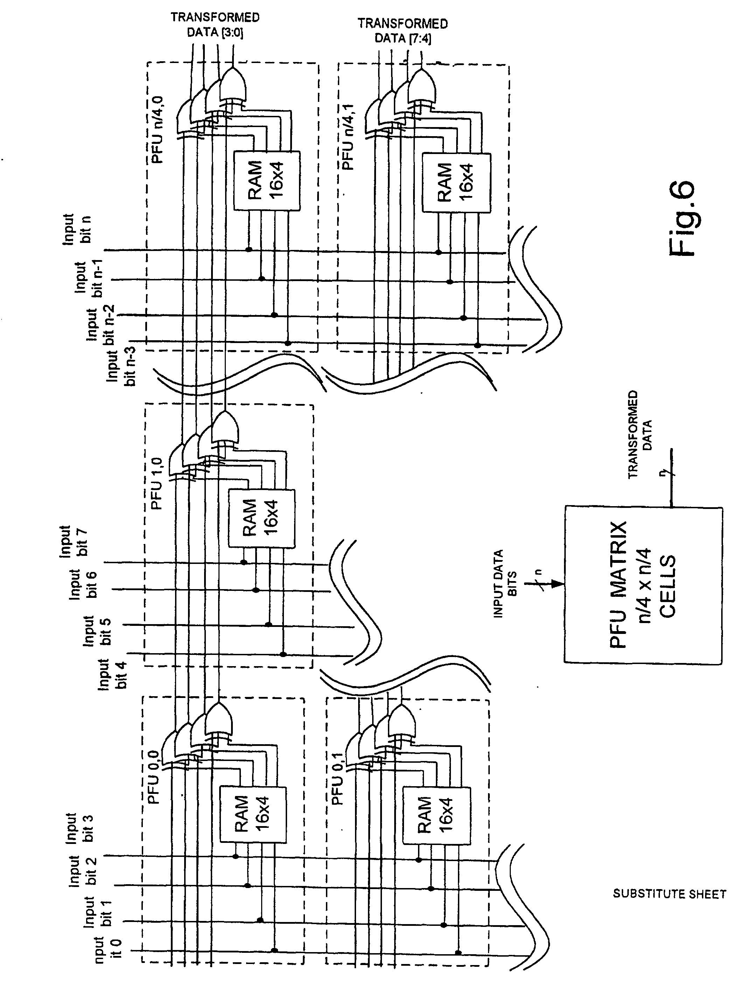

For example, to realise the above transformation means according to the preferred embodiment as discussed above, Lucent ORCA2A memory devices can be used, each memory device consisting of 16 x 4 memory cells, as shown in Fig.6. In this case, the transformation means will require 8 x 8 = 64 PFU's (Programmable Function Units) for storing data and 32 x 1 PFU's for calculating the XOR operation for each bit of the output vector. The result will be even greater saving of the FPGA area and the greater acceleration of the system.

Another important feature of the proposed technical solution is that the transformation means may be easily pipelined at the input of the means, then at the output of each memory cell, and finally at the output of the means. The pipelining permits to have just one logic level between registers, thus maintaining the maximal frequency possible, i. e. more that 150 MHz, and therefore, increasing the accuracy and speed of processing.

As the above described transformation procedure increases greatly the data flow transmitted through a SCSI bus (Small Computer System Interface, ANSI X3.131-1993, publ. 11 West 42 Street, NY, NY, 10036), to avoid the transfer rate limitations within the tester, first, the compressed data may be transferred through SCSI, and then, the transformation procedure may be carried out using the transformation means according to any of the embodiments of the present invention.

A software program for performing the above described method of transformation or carrying out functions of the above discussed transformation means can be also created in any suitable computer language, e.g. C, C++, any kind of Assembler or another language, in a manner evident for a person skilled in the art.

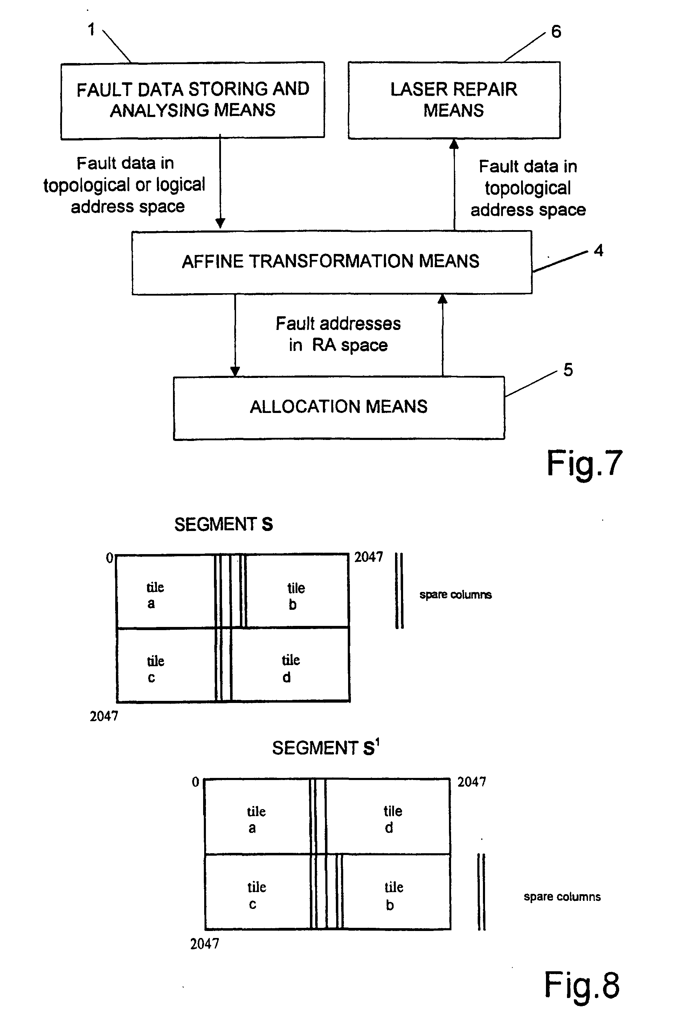

Fig. 7 and Fig.8 illustrate the application of the affine transformation means according to the present invention to memory redundancy allocation.

The memory redundancy allocation system shown in Fig.7 consists of a fault data storing and analysing means 1, an allocation means 2 for creating a repair solution for a memory device, a laser repair means 3, and a transformation means 4. During transmission from the storing system 1 to the allocation means 2 the address data are transformed (scrambled) in the transformation means 4 from logical space into the address space appropriate for redundancy allocation procedures. When the resulting addresses are transmitted to the laser repair means 3, the scrambled addresses are descrambled using the transformation means 4 into topological addresses.

Fig.8 illustrates how the transformation means may be used in conjunction with memory redundancy allocation using as an example a memory device divided into 4 tiles having mutual spare resources. The object of the transformation means in this case is transforming cell addresses for representing or modifying constraints between memory tiles that are physically separate on the actual memory device. The use of the affine transformation allows the rapid mapping of physically separate regions sharing constraints into adjacent regions that fit the industry standard Domain and Region model for redundancy allocation (further RA), while retaining the ability to convert the result back into the physical domain in order to output the redundancy allocation results. By use of an affine transformation means, it is possible to reduce considerably the complexity of the constraint set for redundancy allocation in advanced memory devices. For example, in Fig.8 a memory segment S consisting of a four tiles **a, b, c, d** (where tiles b and c are physically separate memory arrays) may be transformed into a segment $S^1$ in which tiles b and c share mutual spare resources by applying the following affine transformation.

Let the first picture (segment **S**) represent the physical layout (bits **PRO,....PR5, PCO...PC5)** and the second picture represent the RA layout (bits **RRO,....RR5, RCO...RC5).** The formulas would be:

| | |
|---|---|
| RR0 = PR0 | RC0 = PC0^!PC5 |
| RR1 = PR1 | RC1 = PC1^!PC5 |
| RR2 = PR2 | RC2 = PC2^!PC5 |
| RR3 = PR3 | RC3 = PC3^!PC5 |
| RR4 = PR4 | RC4 = PC4^!PC5 |
| RR5 = PR5^PC5 | RC5 = PC5 |

The transformed segment $S^1$ may be subjected then to redundancy allocation in accordance with any suitable known procedures. The transformation is implemented by conversion of the defined constraints into an affine mapping represented by use of a vector or a succinct table.

It will be appreciated that the above is example embodiments only and that various modifications may be made to the embodiments described above within the scope of the present invention.

**Claims**

1. A transformation means for transforming memory cell addresses between different address spaces of a memory device formed from physical structures organised into memory cells, *characterised in that* the transformation means performs a configurable mapping represented as an affine transformation in $P^n$ space, where **n** denotes the total number of bits in an address, and **P** is the modulo 2 field, and comprises:

   an address receiving means for receiving memory cell addresses in one address space and combining bits of address components into an input bit vector;
   a means for representing transformation formulas in the form of a mapping matrix and a translation vector;
   a means for multiplying the input bit vector by the mapping matrix, and further adding a translation vector to the result to obtain the output vector in another address space.

2. A means according to claim 1, *characterised in that* bits of row, column and DQ addresses are combined into one joined input bit vector, DQ being the number of the plane in logical address.

3. A means according to claim 1, *characterised in that* bits of address components, such as row and column address bits, are combined in such a way that they are aligned so that the position of the least significant bits of each row and column component is fixed according to the admissible word width, to obtain an aligned input bit vector.

4. A means according to any one of claims 1 to 3, *characterised in that* the reverse transformation is performed by using the reverse matrix.

5. A means according to any one of claims 1 to 4, *characterised in that* the transformation means stores the transformation map as an n x n matrix of bits and an n x **1** translation vector, where **n** denotes the total number of bits in an address.

6. A means according to any one of claims 1 to 5, *characterised in that* the transformation means is implemented in hardware.

7. A means according to any one of claims 1 to 6, *characterised in that* the transformation is performed by using the transposed matrix.

8. A means according to any one of claims 1 to 7, *characterised in that* look-up tables containing pre-calculated values for an output address vector are used to perform the transformation.

9. A computer implemented method for storing and transforming memory address data comprising the transformation of addresses between different address spaces of a memory device formed from physical structures organised into memory cells, *characterised in that* the transformation is performed as an affine transformation in $P^n$ space, where **n** denotes the total number of bits in an address, and **P** is the modulo 2 field,by combining bits of address components into an input bit vector which is received by an address receiver in one address space and which is multiplied by a mapping matrix which represents the transformation formulas and further adding a translation vector to the result to obtain the output vector in another address space.

10. A system for testing and analysing a memory device (3) formed from physical structures organized into memory cells, the system comprising a fault data storing and analysing means (1) and a testing means (2) provided with a transformation means (4) for transforming addresses between logical address space and topological address space, *characterised in that* the transformation means is the transformation means according to claim 1.

11. A method of testing and analysing a memory device formed from physical structures organised into memory cells including a step of testing a memory device using a cell address transformation and a step of storing and analysing the fault data, *characterised in that* the cell address transformation step is performed according to method 9.

12. A memory redundancy allocation system comprising a fault data storing and analysing means (1) and an allocation means (5), *characterised in that* the system further contains transformation means (4) for transforming cell addresses, which means represents or modifies constraints between memory regions that are physically separate on the actual memory device by applying the affine transformation defined in claim 1 in $P^n$ space, where **n** denotes the total number of bits in an address, and **P** is the modulo 2 field, to map regions sharing a mutual constraint or a mutual spare resource into adjacent regions in a mapping space for the purpose of redundancy allocation.

13. A method of memory redundancy allocation including a step of storing and analysing fault data and a step of redundancy allocation, *characterised in that* the method further includes a step of transforming cell addresses for representing or modifying constraints between memory regions that are physically separate on the actual memory device by applying the affine transformation defined in claim 1 in $P^n$ space, where **n** denotes the total number of bits in an address, and **P** is the modulo 2 field, to the map regions sharing a mutual constraint or a mutual space resource into adjacent regions in a mapping space for the purpose of redundancy allocation.

**Patentansprüche**

1. Transformationseinrichtung zum Transformieren von Speicherzellenadressen zwischen unterschiedlichen Adreßräumen eines Speicherbauelements, welches aus in Speicherzellen organisierten physikalischen Strukturen ausgebildet ist, *dadurch gekennzeichnet, daß* die Transformationseinrichtung eine konfigurierbare Abbildung ausführt, welche als eine affine Transformation in einem $P^n$-Raum dargestellt ist, wobei **n** die Gesamtanzahl von Bits in einer Adresse bezeichnet und **P** das Modulo-2-Feld ist, und aufweist:

   eine Adressenempfangseinrichtung zum Empfangen von Speicherzellenadressen in einem Adreßraum und Kombinieren von Bits von Adressenkomponenten in einem Eingangsbitvektor;

   eine Einrichtung zum Darstellen von Transformationsformeln in der Form einer Abbildungsmatrix und eines Übersetzungsvektors;

   eine Einrichtung zum Multiplizieren des Eingangsbitvektors mit der Abbildungsmatrix und weiter zum Addieren eines Übersetzungsvektors zu dem Ergebnis, um den Ausgangsvektor in einem anderen Adreßraum zu erhalten.

2. Vorrichtung gemäß Anspruch 1, *dadurch gekennzeichnet, daß* Bits von Zeilen-, Spalten- und DQ-Adressen in einem gemeinsamen Eingangsbitvektor kombiniert werden, wobei DQ die Nummer der Ebene in einer logischen Adresse ist.

3. Vorrichtung gemäß Anspruch 1, *dadurch gekennzeichnet, daß* Bits von Adreßkomponenten wie etwa Zeilenund Spaltenadreßbits in einer Weise kombiniert werden, daß sie so ausgerichtet sind, daß die Position der hiederwertigsten Bits jeder Zeilen- und Spaltenkomponente gemäß der zulässigen Wortlänge fixiert ist, um einen ausgerichteten Eingangsbitvektor zu erhalten.

4. Vorrichtung gemäß einem der Ansprüche 1 bis 3, *dadurch gekennzeichnet, daß* die Umkehrtransformation unter Verwendung der Umkehrmatrix durchgeführt wird.

5. Vorrichtung gemäß einem der Ansprüche 1 bis 4, *dadurch gekennzeichnet, daß* die Transformationseinrichtung die Transformationsabbildung als eine n x n-Bitmatrix und einen n x 1-Übersetzungsvektor speichert, wobei **n** die Gesamtanzahl von Bits in einer Adresse anzeigt.

6. Vorrichtung gemäß einem der Ansprüche 1 bis 5, *dadurch gekennzeichnet, daß* die Transformationseinrichtung in Hardware umgesetzt ist.

7. Vorrichtung gemäß einem der Ansprüche 1 bis 6, *dadurch gekennzeichnet, daß* die Transformation unter Verwendung der transponierten Matrix durchgeführt wird.

8. Vorrichtung gemäß einem der Ansprüche 1 bis 7, *dadurch gekennzeichnet, daß* Nachschlagetabellen, welche vorberechnete Werte für einen Ausgangsadreßvektor enthalten, verwendet werden, um die Transformation durchzuführen.

9. In einem Computer umgesetztes Verfahren zum Speichern und Transformieren von Speicheradreßdaten, welche die Transformation von Adressen zwischen unterschiedlichen Adreßräumen und ein aus in Speicherzellen organisierten physikalischen Strukturen ausgebildetes Speicherbauelement aufweist, *dadurch gekennzeichnet, daß* die Transformation als eine affine Transformation in einem $P^n$-Raum, wobei **n** die Gesamtanzahl von Bits in einer Adresse bezeichnet und **P** das Modulo-2-Feld ist, durch Kombinieren von Bits von Adreßkomponenten in einem Eingangsbitvektor, welcher durch eine Adressenempfangseinrichtung in einem Adreßraum empfangen wird, und welcher mit einer Abbildungsmatrix, welche die Transformationsformeln darstellt, multipliziert wird und weiter durch Addieren eines Übersetzungsvektors zu dem Ergebnis durchgeführt wird, um den Ausgangsvektor in einem anderen Adreßraum zu erhalten.

10. System zum Prüfen und Analysieren eines Speicherbauelements (3), welches aus in Speicherzellen organisierten physikalischen Strukturen ausgebildet ist, wobei das System eine Fehlerdatenspeicher- und -analyseeinrichtung (1) und eine mit einer Transformationseinrichtung (4) zum Transformieren von Adressen zwischen einem logischen Adreßraum und einem topologischen Adreßraum ausgestatteten Prüfeinrichtung (2) aufweist, *dadurch gekennzeichnet, daß* die Transformationseinrichtung die Transformationseinrichtung gemäß Anspruch 1 ist.

11. Verfahren zum Prüfen und Analysieren eines Speicherbauelements, welches aus in Speicherzellen organisierten physikalischen Strukturen ausgebildet ist, einschließlich eines Schritts eines Prüfens eines Speicherbauelements unter Verwendung einer Zelladressentransformation und eines Schritts eines Speicherns und Analysierens der Fehlerdaten, *dadurch gekennzeichnet, daß* der Zelladressentransformationsschritt gemäß dem Verfahren 9 durchgeführt wird.

12. Speicherredundanzallokationssystem, welches eine Fehlerdatenspeicher- und -analyseeinrichtung (1) und eine Allokationseinrichtung (5) aufweist, *dadurch gekennzeichnet, daß* das System weiter eine Transformationseinrichtung (4) zum Transformieren von Zelladressen aufweist, wobei die Einrichtung, um Gebiete, welche eine gemeinsame Randbedingung oder eine gemeinsame Ersatzressource teilen, in benachbarte Gebiete in einem Abbildungsraum zum Zwecke einer Redundanzallokation abzubilden, durch Anwenden der in Anspruch 1 definierten affinen Transformation in einem $P^n$-Raum, wobei **n** die Gesamtanzahl von Bits in einer Adresse bezeichnet und **P** das Modulo-2-Feld ist, Randbedingungen zwischen Speichergebieten, welche auf dem tatsächlichen Speicherbauelement physikalisch getrennt sind, darstellt oder modifiziert.

13. Verfahren einer Speicherredundanzallokation einschließlich eines Schritts eines Speicherns und Analysierens von Fehlerdaten und eines Schritts einer Redundanzallokation, *dadurch gekennzeichnet, daß* das Verfahren weiter einen Schritt eines Transformierens von Zelladressen zum Darstellen oder Modifizieren von Randbedingungen zwischen Speichergebieten, welche auf dem tatsächlichen Speicherbauelement physikalisch getrennt sind, durch Anwenden der in Anspruch 1 definierten affinen Transformation in einem $P^n$-Raum, wobei **n** die Gesamtanzahl von Bits in einer Adresse bezeichnet und **P** das Modulo-2-Feld ist, um Regionen, welche eine gemeinsame Randbedingung oder eine gemeinsame Ersatzressource teilen, zum Zwecke einer Redundanzallokation in benachbarte Gebiete in einem Abbildungsraum abzubilden.

**Revendications**

1. Moyens de transformation destinés à transformer des adresses de cellules de mémoire entre différents espaces d'adresses d'un dispositif de mémoire formé à partir de structures physiques organisées en cellules de mémoire, **caractérisés en ce que** les moyens de transformation effectuent une cartographie configurable représentée comme une transformation affine en $P^n$ espace, où n désigne le nombre total de bits dans une adresse, et P est le modulo 2 champ, et comprend :

   des moyens de réception d'adresses pour recevoir des adresses de cellules de mémoire dans un espace d'adresses et combiner les bits de composants d'adresses dans un vecteur de bit d'entrée;
   des moyens pour représenter des formules de transformation sous la forme d'une matrice de cartographie et un vecteur de traduction;
   des moyens pour multiplier le vecteur de bit d'entrée par la matrice de cartographie, et pour ajouter encore un vecteur de traduction au résultat pour obtenir le vecteur de sortie dans un autre espace d'adresses.

2. Moyens selon la revendication 1, **caractérisés en ce que** les bits de rangée, colonne et adresses DQ sont combinés en un vecteur de bit d'entrée commun, DQ étant le numéro du plan dans l'adresse logique.

3. Moyens selon la revendication 1, **caractérisés en ce que** les bits des composants d'adresses, tels que les bits d'adresses de colonne et de rangée, sont combinés de façon à être alignés de telle sorte que la position des bits de signification moindre de chaque composant de colonne et de rangée est fixée selon la largeur de mot admissible, pour obtenir un vecteur de bit d'entrée aligné.

4. Moyens selon l'une quelconque des revendications 1 à 3, **caractérisé en ce que** la transformation inverse est effectuée en utilisant la matrice inverse.

5. Moyens selon l'une quelconque des revendications 1 à 4, **caractérisés en ce que** les moyens de transformation stockent la carte de transformation en tant que matrice n x n et un vecteur de traduction n x 1, où n désigne le nombre totale de bits dans une adresse.

6. Moyens selon l'une quelconque des revendications 1 à 5, **caractérisés en ce que** les moyens de transformation sont mis en oeuvre en matériel (hardware).

7. Moyens selon l'une quelconque des revendications 1 à 6, **caractérisés en ce que** la transformation est effectuée en utilisant la matrice transposée.

8. Moyens selon l'une quelconque des revendications 1 à 7, **caractérisés en ce que** les tables de consultation contenant des valeurs pré-calculées pour un vecteur d'adresses de sortie sont utilisée pour effectuer la transformation.

9. Procédé informatisé pour stocker et transformer des données d'adresses de mémoire comprenant la transformation des adresses entre différents espaces d'adresses d'un dispositif de mémoire formé à partir de structures physiques organisées en cellules de mémoire, **caractérisé en ce que** la transformation est effectuée en tant que transformation affine dans l'espace $p^n$, où n désigne le nombre total de bits dans une adresse, et P est le modulo 2 champ, en combinant les bits de composants d'adresses dans un vecteur de bit commun qui est reçu par un receveur d'adresses dans un espace d'adresses et qui est multiplié par une matrice de cartographie qui représente les formules de transformation et en ajoutant encore un vecteur de traduction au résultat pour obtenir le vecteur de sortie dans un autre espace d'adresse.

10. Système pour tester et analyser un dispositif de mémoire (3) formé à partir de structures physiques organisées en cellules de mémoire, le système comprenant des moyens de stockage et d'analyse des données de défaut (1) et des moyens de test (2) munis de moyens de transformation (4) pour transformer les adresses entre l'espace d'adresses logiques et l'espace d'adresses topologiques, **caractérisé en ce que** les moyens de transformation sont les moyens de transformation selon la revendication 1.

**11.** Procédé pour tester et analyser un dispositif de mémoire formé à partir de structures physiques organisées en cellules de mémoire, comprenant une étape consistant à tester un dispositif de mémoire en utilisant une transformation d'adresses de cellules et une étape de stockage et d'analyse des données de défaut, **caractérisé en ce que** l'étape de transformation d'adresses de cellules est effectuée selon le procédé 9.

**12.** Système d'affectation de redondance de mémoire comprenant des moyens de stockage et d'analyse des données de défaut (1) et des moyens d'affectation (5), **caractérisé en ce que** le système contient de plus des moyens de transformation (4) pour transformer des adresses de cellules, lesquels moyens représentent ou modifient des contraintes entre des régions de mémoire qui sont physiquement séparées sur le dispositif de mémoire réel en appliquant la transformation affine de la revendication 1 dans l'espace $P^n$, où n désigne le nombre total de bits dans une adresse, et P est le modulo 2 champ, pour cartographier les régions partageant une contrainte commune ou une ressource d'espace commune dans des régions adjacentes dans un espace de cartographie dans le but d'une affectation de redondance.

**13.** Procédé d'affectation de redondance de mémoire comprenant une étape de stockage et d'analyse de données de défaut et une étape d'affectation de redondance,
**caractérisé en ce que** le procédé comprend de plus une étape de transformation d'adresses de cellules pour représenter ou modifier des contraintes entre des régions de mémoire qui sont physiquement séparées sur le dispositif de mémoire réel en appliquant la transformation affine définie dans la revendication 1 dans l'espace $P^n$, où n désigne le nombre total de bits dans une adresse, et P est le modulo 2 champ, aux régions de cartographie partageant une contrainte commune ou un espace de ressource commune dans des régions adjacentes dans un espace de cartographie dans le but d'une affectation de redondance.

3

Memory Device Under Treatment

Addresses          Data

2

4

TESTING MEANS          TRANSFORMATION MEANS

Fault addresses

1

FAULT DATA STORING AND ANALYSING MEANS

Fig.1

**Physical address, $V^{PH}_{JOINED}$**

| | | |
|---|---|---|
| E | 0 | PR0 |
| | 1 | PR1 |
| | 1 | PR2 |
| | 1 | PR3 |
| F | 1 | PR4 |
| | 1 | PR5 |
| | 1 | PR6 |
| | 1 | PR7 |
| D | 1 | PR8 |
| | 0 | PR9 |
| | 1 | PR10 |
| | 1 | PR11 |
| 1 | 1 | PR12 |
| | 0 | PR13 |
| E | 0 | PC0 |
| | 1 | PC1 |
| | 1 | PC2 |
| 7 | 1 | PC3 |
| | 1 | PC4 |
| | 1 | PC5 |
| | 1 | PC6 |
| 0 | 0 | PC7 |
| | 0 | PC8 |
| | 0 | PC9 |
| | 0 | PC10 |

**Translation vector t**

Row bits:
1 1 1 1 1 1 1 1 1 1 1 1 1 0

Col bits:
0 0 0 0 0 0 0 0 0 0 1

**Affine transformation matrix $M_{JOINED}$**

```
0000 00000000 1000000000001
0000 00000000 1000000000010
0000 00000000 1000000000100
0000 00000000 1000000001000
0000 00000000 1000000010000
0000 00000000 1000000100000
0000 00000000 1000001000000
0000 00000000 1000010000000
0000 00000000 1000100000000
0000 00000000 1001000000000
0000 00000000 1010000000000
0000 00000000 1100000000000
0000 00000000 1000000000000
0000 00000000 1000000000000
0001 00000000 0000000000000
0010 00000000 0000000000000
1100 00000001 0000000000000
1100 00000010 0000000000000
1100 00000100 0000000000000
1100 00001000 0000000000000
1100 00010000 0000000000000
1100 00100000 0000000000000
1100 01000000 0000000000000
1100 10000000 0000000000000
1100 00000000 0000000000000
```

**Logical address $U^{LOG}_{JOINED}$**

| | | |
|---|---|---|
| 1 | 1 | LR0 |
| | 0 | LR1 |
| | 0 | LR2 |
| | 0 | LR3 |
| 0 | 0 | LR4 |
| | 0 | LR5 |
| | 0 | LR6 |
| | 0 | LR7 |
| 2 | 0 | LR8 |
| | 1 | LR9 |
| | 0 | LR10 |
| 0 | 0 | LR11 |
| | 0 | LR12 |
| F | 1 | LC0 |
| | 1 | LC1 |
| | 1 | LC2 |
| | 1 | LC3 |
| 1 | 1 | LC4 |
| | 0 | LC5 |
| | 0 | LC6 |
| | 0 | LC7 |
| 2 | 0 | DQ0 |
| | 1 | DQ1 |
| | 0 | DQ2 |
| | 0 | DQ3 |

**Fig.2a**

Input Row, Column, DQ logical addresses

↓

Combine Row, Column and DQ addresses into one Joined bit Vector $U_{JOINED}$

↓

Calculate $V_{JOINED} = t_{JOINED} + M_{JOINED} \times U_{JOINED}$

↓

Decompose $V_{JOINED}$ into Row and Column addresses

↓

Output $V_{JOINED}$

**Fig.2b**

```
                    ┌─────────────────┐
                    │      Start      │
                    └─────────────────┘
                             │
                             ▼
          ╱─────────────────────────────────────╲
         ╱  Take a matrix $M_{JOINED}$ and        ╲
        ╱   a  translation vector $t_{JOINED}$     ╲
       ╱─────────────────────────────────────────╲
                             │
                             ▼
          ┌─────────────────────────────────────┐
          │                                     │
          │ Find the reverse matrix  $M^{-1}_{JOINED}$ │
          │                                     │
          └─────────────────────────────────────┘
                             │
                             ▼
          ╱─────────────────────────────────────╲
         ╱     Input topological row and          ╲
        ╱    column address data in bit form       ╲
       ╱─────────────────────────────────────────╲
                             │
                             ▼
          ┌─────────────────────────────────────┐
          │ Combine row and column topological  │
          │ addresses into one joined bit vector│
          │               $V_{JOINED}$          │
          └─────────────────────────────────────┘
                             │
                             ▼
    ┌───────────────────────────────────────────────────┐
    │ Take the topological address vector $V_{JOINED}$, │
    │ subtract the translation vector $t_{JOINED}$ and  │
    │ multiply the result by the reverse matrix  $M^{-1}_{JOINED}$ │
    │  $U_{JOINED} = M^{-1}_{JOINED} (V_{JOINED} - t_{JOINED})$ │
    └───────────────────────────────────────────────────┘
                             │
                             ▼
    ┌───────────────────────────────────────────────────┐
    │ Decompose $U_{JOINED}$ into row and column addresses │
    └───────────────────────────────────────────────────┘
                             │
                             ▼
                    ┌─────────────────┐
                    │       End       │
                    └─────────────────┘
```

# Fig.3

Input adress $U_{ALIGNED}$

| Output address $V_{ALIGNED}$ | Translation vector t | Non-signif. bits | Col bits | Non-signif bits | Row bits |
|---|---|---|---|---|---|

0000001000011111  0000001000000001

| 0 | PR0 | 1 | 0000000000000000 | 0001000000000001 |
| 1 | PR1 | 1 | 0000000000000000 | 0001000000000010 |
| 1 | PR2 | 1 | 0000000000000000 | 0001000000000100 |
| 1 | PR3 | 1 | 0000000000000000 | 0001000000001000 |
| 1 | PR4 | 1 | 0000000000000000 | 0001000000010000 |
| 1 | PR5 | 1 | 0000000000000000 | 0001000000100000 |
| 1 | PR6 | 1 (Row bits) | 0000000000000000 | 0001000001000000 |
| 1 | PR7 | 1 | 0000000000000000 | 0001000010000000 |
| 1 | PR8 | 1 | 0000000000000000 | 0001000100000000 |
| 0 | PR9 | 1 | 0000000000000000 | 0001001000000000 |
| 1 | PR10 | 1 | 0000000000000000 | 0001010000000000 |
| 1 | PR11 | 1 | 0000000000000000 | 0001100000000000 |
| 1 | PR12 | 1 | 0000000000000000 | 0001000000000000 |
| 0 | PR13 | 0 | 0000000000000000 | 0001000000000000 |
| 0 | Non-significant bits | 0 | 0000000000000000 | 0000000000000000 |
| 0 | | 0 | 0000000000000000 | 0000000000000000 |

= +

| 0 | PC0 | 0 | 0000000100000000 | 0000000000000000 |
| 1 | PC1 | 0 | 0000001000000000 | 0000000000000000 |
| 1 | PC2 | 0 | 0000110000000001 | 0000000000000000 |
| 1 | PC3 | 0 | 0000110000000010 | 0000000000000000 |
| 1 | PC4 | 0 (Col bits) | 0000110000000100 | 0000000000000000 |
| 1 | PC5 | 0 | 0000110000001000 | 0000000000000000 |
| 1 | PC6 | 0 | 0000110000010000 | 0000000000000000 |
| 0 | PC7 | 0 | 0000110000100000 | 0000000000000000 |
| 0 | PC8 | 0 | 0000110001000000 | 0000000000000000 |
| 0 | PC9 | 0 | 0000110010000000 | 0000000000000000 |
| 0 | PC10 | 1 | 0000110000000000 | 0000000000000000 |
| 0 | Non-significant bits | 0 | 0000000000000000 | 0000000000000000 |
| 0 | | 0 | 0000000000000000 | 0000000000000000 |
| 0 | | 0 | 0000000000000000 | 0000000000000000 |
| 0 | | 0 | 0000000000000000 | 0000000000000000 |
| 0 | | 0 | 0000000000000000 | 0000000000000000 |

Affine transformation matrix $M_{ALIGNED}$

**Fig.4a**

( Input Row, Column, DQ address )

↓

Combine Row, Column and DQ addresses into one aligned bit vector $U_{ALIGNED}$

↓

$V_{ALIGNED} = t_{ALIGNED}$

↓

$i = i + 1$

$U_{ALIGNED}[i] = 0$ — Yes

No

↓

Count: $V_{ALIGNED} = U_{ALIGNED} \text{ XOR } M^T_{ALIGNED}$

↓

All rows in $M^T$ are counted by i ? — No

Yes

↓

( Output $V_{ALIGNED}$ )

**Fig.4b**

$V_{ALIGNED}$ $t_{ALIGNED}$ XOR $U_{ALIGNED}$

$M^T_{ALIGNED}$

| Byte 3 | Byte 2 | Byte 1 | Byte 0 |

| Slice 3 | Slice 2 | Slice 1 | Slice 0 |

$$V_{ALIGNED} = t_{ALIGNED} \; XOR \left[ \mathop{XOR}\limits_{i=0}^{3} V_{Si} \left( \text{Byte } i \, (U_{ALIGNED}) \right) \right]$$

Fig.5

| Value of byte 0 | Precalculated values for vector $V_{Slice0}$ (Byte0($U_{Aligned}$)) |
|---|---|
| 0x00 | 0x 00 00 00 00 |
| 0x01 | 0x 00 00 00 01 |
| 0x02 | 0x 00 00 00 02 |
| 0x03 | 0x 00 00 00 03 |
| 0x04 | 0x 00 00 00 04 |
| 0xFF | 0x 00 00 00 FF |

| Value of byte 1 | Precalculated values for vector $V_{Slice1}$ (Byte1($U_{Aligned}$)) |
|---|---|
| 0x00 | 0x 00 00 00 00 |
| 0x01 | 0x 00 00 01 00 |
| 0x02 | 0x 00 00 02 00 |
| 0x03 | 0x 00 00 03 00 |
| 0x04 | 0x 00 00 04 00 |
| 0xFF | 0x 00 00 03 FF |

| Value of byte 2 | Precalculated values for vector $V_{Slice2}$ (Byte2($U_{Aligned}$)) |
|---|---|
| 0x00 | 0x 00 00 00 00 |
| 0x01 | 0x 00 04 00 00 |
| 0x02 | 0x 00 0B 00 00 |
| 0x03 | 0x 00 0C 00 00 |
| 0x04 | 0x 00 10 00 00 |
| 0xFF | 0x 03 FC 00 00 |

| Value of byte 3 | Precalculated values for vector $V_{Slice3}$ (Byte3($U_{Aligned}$)) |
|---|---|
| 0x00 | 0x 00 00 00 00 |
| 0x01 | 0x 00 00 01 00 |
| 0x02 | 0x 00 00 02 00 |
| 0x03 | 0x 00 00 03 00 |
| 0x04 | 0x 00 00 04 00 |
| 0xFF | 0x 00 03 00 00 |

17

Fig.6

**Fig.7**

**Fig.8**